Europäisches Patentamt

European Patent Office

Office européen des brevets

(19)

(11) Publication number: **0 460 726 A1**

# (12) EUROPEAN PATENT APPLICATION

(21) Application number: 91201165.7

(22) Date of filing: 15.05.91

(51) Int. Cl.⁵: **C23C 18/12**

(30) Priority: 04.06.90 US 533213

(43) Date of publication of application:
**11.12.91 Bulletin 91/50**

(84) Designated Contracting States:
**DE FR GB**

(71) Applicant: **GENERAL MOTORS CORPORATION**
**General Motors Building 3044 West Grand**
**Boulevard**
**Detroit Michigan 48202(US)**

(72) Inventor: **Micheli, Adolph Louis**
**38900 Elmite**
**Mt. Clemens, MI 48045(US)**
Inventor: **Schubring, Norman William**
**2723 Avonhurst Drive**
**Troy, MI 48084(US)**
Inventor: **Mantese, Joseph Vito**
**3255 Wolverine**
**Troy, MI 46083(US)**
Inventor: **Catalan, Antonio Buddy**
**3658 Merrimac**
**Sterling Heights, MI 4831D(US)**

(74) Representative: **Haines, Arthur Donald et al**
**Patent Section Vauxhall Motors Limited 1st**
**Floor Gideon House 26 Chapel Street**
**Luton, Bedfordshire LU1 2SE(GB)**

(54) Formation of potassium tantalate niobate thin films by metallorganic deposition.

(57) Thin films of potassium tantalum niobate, $KTa_{1-x}Nb_xO_3$, (KTN), material are deposited using the non-vacuum technique of metallorganic deposition. Firstly a suitable metallorganic precursor dissolved in solution, preferably the carboxylates of potassium, tantalum and niobium in xylene, is dispensed onto a substrate much like photoresist. The substrate, preferably platinum or platinum-coated yttria but also foreseeably $CaF_2$, $BaF_2$ or $Er_2O_3$, is spun at a few thousand revolutions per minute to remove the excess fluid, driving off the xylene solvent and uniformly coating the substrate surface with a metallorganic film a few micrometres thick. The soft metallorganic film is then pyrolyzed in an air atmosphere to convert the metallorganic precursors to their constituent oxides, and is subsequently annealed to form a perovskite crystal structure throughout the film. Superior films are formed when the metallorganic precursor solution is potassium-deficient as compared to stoichiometry, and is then subsequently annealed after pyrolysis in a potassium-rich environment to form stoichiometric metal oxide films. The resulting films exhibit uniform, high quality physical, chemical and electrical properties throughout, and are suitable for the economical fabrication of an uncooled infra-red detector having maximum response characteristics.

This invention relates to the formation of thin metal oxide films by metallorganic deposition techniques as specified in the preamble of claim 1, for example as disclosed in "Metalorganic Deposition (MOD): A Nonvacuum, Spin-on, Liquid-Based, Thin Film Method"; Mantese et al, Materials Research Society Bulletin/October 1989, Pages 48-53.

Thermal-imaging systems have long been used by the military as reliable aids for night-vision surveillance. While thermal-imagers are most often used for night-vision enhancement, such systems are also used in fog, haze, rain and snow. It is therefore foreseeable that a vision-enhancement system containing a thermal-imaging system could be very useful in automotive applications as an effective driving aid in a variety of driving conditions. However, the vision-enhancement systems used by the military are prohibitively expensive for automotive applications.

Current, state-of-the-art, military imaging devices make use of various sensor materials and detector geometries. Some of the more successful materials include: $Hg_{1-x}Cd_xTe$, $Pb_2Se$ and $PtSi$ Schottky diodes. Thermal-imaging systems based upon these materials and technologies have been demonstrated and the manufacturability of the systems has been proven.

However, the primary obstacles for the low-cost production of these vision enhancement systems appear to be the complex infra-red (IR) scanning systems and the costly multi-stage cooling systems required to cool the sensing elements to their operating temperatures.

Therefore, it would be desirable to provide an alternative, cost-effective detection scheme which would make use of an array of uncooled sensors in a staring rather than a scanning system to detect infra-red radiation, preferably in either the 3-5 micrometre or 8-12 micrometre wavelength range. Previously, uncooled vision-enhancement systems based upon the detection of infra-red radiation have been formed primarily from three materials; potassium tantalum niobate, $KTa_{1-x}Nb_xO_3$ (KTN); barium strontium titanate, $Ba_{1-x}Sr_xTiO_3$ (BST); and lanthanum-doped lead zirconate titanate, $PbZr_{1-x}Ti_xO_3$ (PZT). These materials are similarly characterized by both a perovskite crystal structure and a large pyroelectric coefficient, making them useful as infra-red detectors.

Both the KTN and BST materials have Curie temperatures which may be varied by appropriately varying the ratios of their chemical constituents. Because of this property, the maximum infra-red response of either KTN or BST may be adjusted to any temperature around ambient temperature, making them especially attractive for high-volume, uncooled infra-red detection. Theoretical calculations based upon their pyroelectric coefficients, emissivities, volume specific heats, and other parameters suggest that the sensitivity of the KTN films should be a factor of about four more sensitive to infra-red radiation than the BST films. Therefore it would appear that the use of KTN films is the preferred material for the formation of relatively inexpensive, high-volume, uncooled, infra-red detectors.

A typical staring-type infra-red detector formed from KTN would preferably consist of an array of pixels, approximately 50 micrometre in size, formed from an approximately 5 micrometre thick film. Ideally, each pixel would be formed from single crystal material for maximum detector response. Alternatively, a polycrystalline film may be used if the grain sizes are sufficiently large that the pyroelectric coefficients of the grains are substantially equal to that of the single crystal. However if polycrystalline films are used, chemical inhomogeneities over the dimension of the detector array would have to be minimized so as not to result in variations in Curie temperature within the individual pixels.

Therefore, whilst the preferred infra-red pyroelectric detector array would consist of reticulated 5 micrometre-thick single crystal pixels formed from KTN material, this is impractical for high-volume production purposes due to the difficulties in (1) growing chemically uniform single crystals of KTN of sufficient diameter, (2) slicing and thinning the crystals to 5 micrometre thickness and (3) reticulating the crystals to form the pixels. Thus, it is essential for the economical fabrication of an uncooled infra-red detector having maximum response to have the capability to: (1) deposit thin films approximately 5 micrometres thick of KTN material, (2) obtain chemical, physical and dimensional uniformity of the films over the dimensions of the detector array, and (3) deposit films of a maximum grain size so as to most closely replicate the properties of single crystal material. However, previous attempts to deposit KTN films having these characteristics have proven unsuccessful, such as with sputter deposition or chemical vapor deposition techniques.

It is apparent that what is needed is a method for depositing thin films of KTN having a maximum grain size and uniform properties, which would be suitable for use in infra-red detectors.

A method for producing metal oxide films according to the present invention is characterised by the features specified in the characterising portion of claim 1.

It is an object of the present invention to provide thin films of KTN material which are suitable for use in infra-red detectors.

It is a further object of this invention to provide a method for forming such films.

In accordance with the preferred embodiment of this invention, these and other objects and advantages are accomplished as follows.

The inventors are the first to deposit thin films of potassium tantalum niobate, $KTa_{1-x}Nb_xO_3$, or KTN, material using a non-vacuum technique of metallorganic deposition. First, a suitable metallorganic precursor dissolved in solution, preferably the carboxylates of potassium, tantalum and niobium in xylene, is dispensed onto a substrate much like photoresist. The substrate, preferably formed from platinum, is spun at a few thousand revolutions per minute to remove the excess fluid, driving off the xylene solvent and uniformly coating the substrate surface with a metallorganic film a few micrometres thick. Other suitable substrate materials include not only platinum, but platinum-coated yttria, $Y_2O_3$, and also foreseeably platinum-coated $CaF_2$, $BaF_2$ and $Er_2O_3$. The soft metallorganic film is then pyrolyzed in an air atmosphere to convert the metallorganic precursors to their constituent oxides, and subsequently annealed to form a perovskite crystal structure throughout the film.

An inventive feature of this invention is in the determination that superior films are formed using the metallorganic deposition method of the invention when the metallorganic precursor solution is potassium-deficient as compared to stoichiometry, and then the films are subsequently annealed after pyrolysis in a potassium-rich environment to form stoichiometric metal-oxide films. The resulting films exhibit uniform, high-quality physical, chemical and electrical properties throughout.

The KTN films formed in this manner have a peak dielectric constant ranging between about 7800 to about 11000 at a Curie temperature of about 9° C with a corresponding pyroelectric coefficient, $P_F$, equal to about $1.22 \times 10^{-8}$ C/cm²-° C to about $5.0 \times 10^{-8}$ C/cm²-° C. X-ray diffraction analysis confirms the presence of the KTN perovskite crystal structure in the films. Scanning electron microscopy reveals grain size of the films of the order of about 1-10 micrometres.

The KTN films formed in this manner are suitable for the economical fabrication of an uncooled infra-red detector having maximum response characteristics.

Other objects and advantages of this invention will be better appreciated from a detailed description thereof, which follows.

Thin films of KTN were formed on platinum foil substrates by metallorganic deposition techniques. This method generally consists of the steps of: (1) flooding the surface of a suitable substrate, such as a platinum substrate, with metal carboxylates dissolved in xylene, (2) spinning the substrate at a high rate of speed to uniformly coat the platinum substrate with the organic solution and to drive off the xylene, (3) pyrolyzing the remaining organic material to convert the carboxylates to their metal oxides, and (4) annealing the films to form the perovskite crystal structure essentially throughout the films.

The preferred potassium tantalum niobate, $KTa_{1-x}Nb_xO_3$, or KTN, films were prepared by first synthesizing appropriate metallorganic precursors from the carboxylates of the metals. Carboxylates refer to the metallorganic precursor formed by the bonding of a metal ion to a carboxylic acid. Although the carboxylates are preferred because they form superior films, other metallorganic compounds may be utilized. Specifically, tantalum and niobium compounds were prepared by reacting their ethoxides with neodecanoic acid to form the diethoxide trineodecanoates having the corresponding formulas $Ta(C_{10}H_{19}O_2)_3(C_2H_5O)_2$ and $Nb(C_{10}H_{19}O_2)_3(C_2H_5O)_2$. The potassium compound was formed by reacting potassium hydroxide in methanol with neodecanoic acid to form potassium neodecanoate ($KC_{10}H_{19}O_2$). These metallorganics were dissolved in xylene at a preferred ratio of about 1 millilitre of solvent to about 1 gram of compound to form the desired KTN metallorganic solution.

The composition of the metallorganic solution was adjusted to obtain a film with a Curie temperature near room temperature. The Curie temperature is the temperature at which the transition between a ferroelectric and non-ferroelectric phase occurs. For KTN material, the Curie temperature may be varied by adjusting the tantalum (Ta) to niobium (Nb) ratio. For KTN, the dielectric constant and pyroelectric coefficient peak at the Curie temperature making KTN especially useful for IR detection. The composition of a preferred KTN neodecanoate solution having a Curie temperature near room temperature is approximately:

Tantalum diethoxide trineodecanoate = 25 g

Niobium diethoxide trineodecanoate = 10 g

Potassium neodecanoate = 22 g

and about 57 millilitres xylene to dissolve.

The metallorganic solution was spun at approximately 2000 revolutions per minute for about 20 seconds onto a platinum substrate and then pyrolized by very quickly placing the substrate directly into an air atmosphere furnace pre-set at about 600° C. Other suitable substrates include not only the platinum substrate, but platinum-coated $Y_2O_3$ and foreseeably platinum-coated $CaF_2$, $BaF_2$ and $Er_2O_3$. The duration at this temperature is about one to two minutes so as to ensure complete pyrolization of the metallorganic compounds into their respective metal oxides. The film thickness after pyrolysis is approximately 0.2 micrometres per spin cycle. Samples having a film thickness of only about 0.2 micrometres which were prepared after only a single spin-pyrolization step exhibited excessive cracking and a mottled surface. Therefore, it is preferable to form a film of approximately 5 to 8 micrometres in thickness. This is achieved by by repeating the spin-pyrolization steps up to about 40 times.

An inventive feature of this invention is that the amount of potassium (K) in the KTN metallorganic solution is preferably about 20% lower than the stoichiometric amount. The inventors determined that this potassium-deficient metallorganic solution forms superior films compared to solutions prepared at stoichiometric levels. Generally, if the potassium content of the metallorganic solution is set near stoichiometry then the film appears opaque and irregular after pyrolysis. With a deficiency of potassium in the metallorganic solution, the films appear uniform and glassy after pyrolysis. However, suitable films may be formed when the potassium content is almost stoichiometric, for films deposited on the platinum-coated $Y_2O_3$ substrates, by varying the pyrolysis rate so that the pyrolysis temperature is maintained for about 7 to 10 minutes. The high integrity and homogeneous qualities of the potassium-deficient films were confirmed by scanning electron microscopy.

After pyrolysis, the films were characterized by an amorphous pattern, as confirmed by X-ray analysis. Because of the potassium deficiency in the films at this point, X-ray analysis indicates KTN peaks along with numerous other peaks.

After pyrolysis, dielectric measurements of the potassium-deficient films reveal a broad Curie temperature peak with a dielectric constant of about 500 at a Curie temperature of about 9° C. The dielectric properties of the film are grain-size dependent, therefore, based on theoretical calculations and confirmed by empirical analysis, continuous KTN films having grain sizes of approximately 5 micrometres or larger are preferred. In order to obtain grain growth to this desired grain size, the films were annealed in a potassium atmosphere at a temperature ranging between about 1150° C to about 1250° C for a duration of about ten minutes to one hour.

It was determined that, to obtain a film having a clear KTN X-ray pattern from the potassium-deficient films, additional potassium has to be added to the film. This was accomplished by baking the potassium-deficient films in a potassium-rich atmosphere at about 900° C to about 1250° C, preferably about 1150° C, for up to about an hour, but preferably about 12 to 18 minutes in a closed platinum crucible placed on a zirconia setter. The crucible was surrounded by, but did not touch, a compound composed of potassium and alumina, preferably about one mole of potassium oxide ($K_2O$) to about 11 moles of aluminium oxide ($Al_2O_3$). After baking the potassium-deficient films in air for preferably about 12 to 18 minutes at about 1150° C with this potassium-aluminate compound, X-ray analysis indicated clean KTN peaks with no additional phases present.

Dielectric measurements taken after the potassium addition to the films reveal dielectric constants at the Curie temperature ranging between about 2000 and 7800 depending on the firing conditions. However, these films tended to have discontinuities along their surfaces. Gold-chrome electrodes placed on the surface of these films were shorted due to the discontinuities. It was determined that, if these films had an additional 10 layers of the metallorganic KTN solution spun on, prior to deposition of the gold-chrome electrodes but after the annealing step, to fill the voids within the film and then were re-fired at about 1100° C to 1150° C in a potassium-rich atmosphere for up to about one hour but preferably about 12 to 18 minutes, a dielectric constant of about 7800 was obtained. However, these additional layers are not always necessary depending on the annealing parameters used. If the films are annealed at the preferred temperature of about 1150° C for about 12 to 18 minutes, the initial layers are continuous and suitable for deposition of the electrodes. Further, the addition of these additional coats enhanced the integrity of these films by filling the voids and pinholes in the films. Therefore, generally by depositing an extra 10, and up to about 20, coats on the films, it was possible to successfully deposit electrodes on the films. It is to be noted that at lower temperatures or shorter firing times the films were continuous but characterized by lower dielectric constants of approximately 2000-4000.

The dielectric constant, $x$ is a function of temperature for KTN films having various tantalum to niobium ratios and which have been processed under a variety of conditions. It was determined that, as the ratio of tantalum to niobium increased, this generally resulted in materials with lower Curie temperatures, $T_c$. In addition, increasing the annealing temperature resulted in increased grain size within the films which simultaneously increased the Curie temperature and the dielectric constant of the thin film material. For practical reasons, the preferred ratio of tantalum to niobium varies between about 2.29 to about 1.43, resulting in a corresponding shift in the Curie temperature of about 100° C from -50° C to about 50° C.

Selection of a tantalum to niobium ratio is not the only parameter selected for obtaining a particular Curie temperature. Varying the annealing temperature from about 950°C to about 1250°C shifts the Curie temperature by about 35°C, when the tantalum to niobium ratio is about 1.77. As the Curie temperature increases, the dielectric constant $x$ rises from about 3000 to 7800. Using this technique, a Curie temperature of about 9°C was obtained for the thin film KTN material having a tantalum to niobium ratio of about 1.77. These results agree with previous work done on bulk single crystal KTN material.

Scanning micrographs revealed that the grain sizes for films annealed at about 1180°C and about 1250°C, with the tantalum to niobium ratio being about 1.77 in both instances, are approximately 1-2 micrometres and approximately 5-10 micrometres, respectively. The larger grain size is preferred since it is characterized by properties more similar to a single crystal film, therefore annealing at about 1250°C is preferred. Annealing the materials much in excess of about 1250°C, when the tantalum to niobium ratio is about 1.77, will lead to the formation of a liquid phase. Since melting tends to lead to the formation of multiphase materials, none of the samples were annealed to temperatures greater than about 1250°C.

X-ray diffraction confirms the formation of single phase KTN material after annealing in a potassium-rich atmosphere at temperatures below about 1250°C. The X-ray diffraction pattern for a powdered single crystal KTN sample having a tantalum to niobium ratio of about 1.5 was compared to the X-ray diffraction pattern for a KTN thin film on a platinum substrate annealed at 1200°C in air and subsequently annealed in a potassium-rich atmosphere, with the tantalum to niobium ratio equal to about 1.77. For both X-ray diffraction patterns, copper $K\alpha$ radiation was used. Except for some platinum peaks due to the underlying substrate, X-ray diffraction analyses indicates that only the KTN phase is present and it is structurally equivalent to the powdered single crystal KTN material.

Pyroelectric coefficients for the preferred KTN films wherein the tantalum to niobium ratio equals about 1.77 and the dielectric constant equals about 7800 are reduced compared to that of those values for single crystal material. Near the Curie temperatures, the dielectric constant $x$ varies much more rapidly and attained a much larger value for the single crystal material as compared to the films formed in accordance with the method of the invention. It was determined that the pyroelectric coefficient for the bulk single crystal material was equal to about $8.3 \times 10^{-8}$ C/cm²-°C at a temperature of about 3°C and a microscopic electric field of about 1.0 kV/cm. The pyroelectric coefficient for the films formed in accordance with the present invention is up to about $5.0 \times 10^{-8}$ C/cm²-°C at a temperature of about 37°C and a microscopic electric field of about 2.5 kV/cm.

Initial studies suggest that the suppression in the dielectric constant of the films formed in accordance with the present invention may arise due to the fact that the KTN films are, at the very least, bi-layers. The bi-layers are composed of a large-grained layer having a high dielectric constant ($x$ approximately equal to 18,000) which is approximately 5-10 micrometres thick, and an overlaying fine-grained low dielectric layer ($x$ approximately equal to 3,000) which is approximately 1-2 micrometres thick. The fine-grained layer arises because of the additional 10-20 KTN layers deposited after annealing at high temperature of the underlying large-grained layer. The overlaying 10-20 layers were necessary to fill the voids and pinholes within the film.

The presence of the fine-grained layer is believed to diminish the underlying large-grained layer properties. It appears that the fine-grained overlaying layer in this bi-layer structure suppresses the dielectric constant, its rate of change with temperature and the pyroelectric coefficient of the underlying large-grained layer.

Generally, the highest quality KTN thin films formed with the method of the present invention have a bi-layer structure consisting of a large-grained layer approximately 7 micrometres thick with grain sizes about 5-10 micrometres in diameter lying below an approximately 2 micrometre-thick, fine-grained layer having grain sizes 1-2 micrometres in diameter. The large-grained layer is determined to having a dielectric constant of 10,000 or greater. The maximum rate of change with temperature of the dielectric constant of the large-grained layer is about 160°C⁻¹ which is greater than either the fine-grained overlayer, 57°C⁻¹, or the bi-layer, 117°C⁻¹. In addition, for the same applied dc field (about 2.5 kVcm), the pyroelectric coefficient of the large-grained layer, about $1.43 \times 10^{-8}$ C/cm²-°C, is greater than either the bi-layer, $1.22 \times 10^{-8}$ C/cm²-°C, or the fine-grained layer, $0.84 \times 10^{-8}$ C/cm²-°C. Although KTN films formed from only the large-grained material would have pyroelectric properties superior to either the fine-grained material or films having the bi-layer structure, the large-grained layer tends to be discontinuous. Therefore, the overlaying fine-grained layer is formed so as to fill any discontinuities in the large-grained underlying layer. The resulting bi-layer KTN films formed with the metalIorganic deposition method of the invention provide superior quality films for infra-red detection.

This invention readily facilitates the formation of high-quality KTN films for infra-red wavelength detection purposes. Whilst the present invention has been described in terms of preferred embodiments, it is apparent that other forms could be adopted by one skilled in the art, such as by modifying the precursor metallorganic materials or the processing parameters. Accordingly, the scope of the present invention is to be limited only by the following claims.

## Claims

1. A method for producing metal oxide films which comprises the steps of forming a solution of metal carboxylates, depositing a film of said solution onto a substrate; and pyrolyzing said deposited film to convert said carboxylates to a film of the corresponding metal oxides thereof, characterised in that the method includes the steps of: forming said solution from carboxylates of potassium, tantalum and niobium, pyrolyzing said film of said solution at a first temperature and duration sufficient to convert said carboxylates to said corresponding metal oxides thereof, but insufficient to significantly recrystallize said oxides; and then annealing said film of metal oxides at a second temperature and duration that is sufficient to promote grain growth of said metal oxides and to essentially recrystallize said metal oxides so as to form a mixed metal oxide of potassium-tantalum-niobate which has a perovskite crystal structure and exhibites sensitivity to infra-red radiation.

2. A method for producing films of potassium-tantalum-niobate according to claim 1, in which said substrate is platinum.

3. A method for producing films of potassium-tantalum-niobate according to claim 1, in which said substrate is platinum-coated yttria, $Y_2O_3$.

4. A method for producing films of potassium-tantalum-niobate according to claim 1, in which said first pyrolyzing step comprises heating said metal oxides in an oxygen-containing atmosphere at a temperature of about $600°C$ and for a duration of about 60 seconds.

5. A method for producing films of potassium-tantalum-niobate according to claim 3, in which said first pyrolyzing step comprises heating said metal oxides in an oxygen-containing atmosphere environment at a temperature of about $600°C$ and for a duration of up to about 10 minutes.

6. A method for producing films of potassium-tantalum-niobate according to claim 1, in which said annealing step comprises heating said film of metal oxides in an oxygen-containing atmosphere, at a temperature that is greater than said pyrolyzing temperature and that is sufficient to promote recrystallization of said metal oxides to form essentially said perovskite crystal structure within said metal oxides.

7. A method for producing films of potassium-tantalum-niobate according to claim 1, in which said annealing step comprises heating said film of metal oxides in a potassium-rich atmosphere, at a temperature that is greater than said pyrolyzing temperature and that is sufficient to promote recrystallization of said metal oxides to form essentially a mixed metal oxide of the perovskite crystal structure within said film.

8. A method for producing films of potassium-tantalum-niobate according to claim 1, in which said annealing step comprises heating said film of metal oxides to a temperature ranging between about $1050°C$ and $1250°C$.

9. A method for producing films of potassium-tantalum-niobate according to claim 1, in which said annealing step comprises heating said film of metal oxides in a potassium-rich atmosphere at a temperature ranging between about $1050°C$ and $1250°C$ for a duration of up to about 60 minutes.

10. A method for producing thin films of potassium-tantalum-niobate according to claim 1, in which said film of said solution is pyrolyzed in an oxygen-containing environment at a temperature of about $600°C$ for about 60 seconds, so as to decompose said carboxylates of potassium, tantalum and niobium into a film containing metal oxides of potassium, tantalum and niobium; said depositing and pyrolyzing steps are repeated as necessary to produce a film of metal oxides of desired thickness; and said film of metal oxides is annealed at a temperature ranging between about $1050°C$ and $1250°C$ and for a duration sufficient to promote recrystallization and grain growth of said metal oxides into a mixed metal oxide essentially comprised of the perovskite crystal structure.

11. A method for producing thin films of potassium-tantalum-niobate according to claim 10, in which said annealing step is performed in a potassium-rich atmosphere at a temperature ranging between about $1050°C$ to $1250°C$ for a duration of up to about 60 minutes.

12. A method for producing thin films of potassium-tantalum-niobate according to claim 1, in which the method includes forming a metallorganic solution consisting of a xylene solvent and the carboxylates of potassium, tantalum and niobium, wherein said metallorganic solution is potassium-deficient as compared to stoichiometry; depositing said film of said solution onto a platinum substrate and spin-coating s platinum substrate with said metallorganic solution and to drive off said xylene solvent from said metallorganic solution thereby leaving a metallorganic film on said substrate; pyrolyzing said metallorganic film in an oxygen-containing environment at a temperature of about 600°C for about 60 seconds, so as to decompose said carboxylates of potassium, tantalum and niobium into a metal oxide film containing oxides of potassium, tantalum and niobium; repeating said depositing and pyrolyzing steps as necessary to produce a metal oxide film of desired thickness; and annealing said metal oxide film in a potassium-rich environment at a temperature ranging between about 1050°C and 1250°C and for a duration sufficient to promote recrystallization and grain growth of said metal oxides so that said metal oxides are essentially comprised of the perovskite crystal structure.

13. A method for producing thin films of potassium-tantalum-niobate according to claim 9, in which the method includes, after said annealing step, the additional steps of: forming a metallorganic solution consisting of a xylene solvent and the carboxylates of potassium, tantalum and niobium; depositing a film of said metallorganic solution onto said film of metal oxides and spin-coating said metallorganic solution at an appropriate rate of speed so as to uniformly coat said film of metal oxides with said metallorganic solution and to drive off said xylene solvent from said metallorganic solution thereby leaving a metallorganic film on said film of metal oxides; pyrolyzing said metallorganic film in an oxygen-containing environment at a temperature of about 600°C for up to about 10 minutes, so as to decompose said carboxylates of potassium, tantalum and niobium therein into a second metal oxide film containing oxides of potassium, tantalum and niobium so as to substantially fill any voids within said annealed first layer of metal oxides; and repeating said depositing and pyrolyzing steps as necessary to produce a film of desired thickness having a mixed metal oxide layer which is characterized essentially by a large-grained perovskite crystal structure and a second metal oxide layer within and on top of said mixed metal oxide layer which is characterized by a fine-grained crystal structure.

14. A method for producing thin films of potassium-tantalum-niobate according to claim 1, in which the method includes the steps of: forming a metallorganic solution consisting of a xylene solvent and the carboxylates of potassium, tantalum and niobium; depositing a film of said solution onto a platinum-coated yttria substrate and spin-coating said substrate at an appropriate rate of speed so as to uniformly coat said platinum-coated yttria substrate with said metallorganic solution and to drive off said xylene solvent from said metallorganic solution, thereby leaving a metallorganic film on said substrate; pyrolyzing said metallorganic film in an oxygen-containing atmosphere at a temperature of about 600°C for up to about 10 minutes, so as to decompose said carboxylates of potassium, tantalum and niobium into a metal oxide film containing oxides of potassium, tantalum and niobium; repeating said depositing and pyrolyzing steps as necessary to produce a film of metal oxides of desired thickness; and annealing said film of metal oxides in a potassium-rich atmosphere at a temperature ranging between about 1050°C and 1250°C and for a duration sufficient to promote recrystallization and grain growth of said metal oxides into a mixed metal oxide essentially comprised of the perovskite crystal structure.

15. A method for producing metal oxide films which comprises the steps of forming a solution of metal carboxylates in a hydrocarbon solvent to form a metallorganic solution, depositing a film of said solution onto a substrate; and pyrolyzing said deposited film to convert said carboxylates to a film of the corresponding metal oxides thereof, characterised in that the method includes the steps of: forming said solution from carboxylates which either yield potassium tantalum niobate, barium strontium titanate, or lanthanum-doped lead zirconate titanate; pyrolyzing said film of said solution at a first temperature and duration sufficient to convert said carboxylates to said corresponding metal oxides thereof, but insufficient to significantly recrystallize said oxides; and then annealing said film of metal oxides at a second temperature and duration that is sufficient to promote grain growth of said metal oxides and to essentially recrystallize said metal oxides so as to form a mixed metal oxide which has a perovskite crystal structure and exhibits sen-

sitivity to infra-red radiation.

16. A metallorganic solution, when used to carry out the method of claim 1, characterised in that the metallorganic solution comprises: a potassium carboxylate; a tantalum carboxylate; a niobium carboxylate; and xylene.

17. A metallorganic solution according to claim 17, in which said amount of potassium carboxylate is deficient as compared to stoichiometry.

European
Patent Office

EUROPEAN SEARCH
REPORT

Application Number

EP 91 20 1165

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | FR-A-2 498 817 (SOLAREX CORP.)<br>— — — | | C 23 C 18/12 |
| A | US-A-3 047 424 (SUCHOFF)<br>* Column 3, line 6 *<br>— — — | | |
| A | US-A-3 293 557 (DENTON)<br>— — — — — | | |

TECHNICAL FIELDS
SEARCHED (Int. Cl.5)

C 23 C
C 04 B

The present search report has been drawn up for all claims

| Place of search | Date of completion of search | Examiner |
|---|---|---|
| The Hague | 01 August 91 | NGUYEN THE NGHIEP |